# FASCICULE DE BREVET EUROPEEN

(11) **EP 2 437 323 B1**
(45) Date de publication et mention de la délivrance du brevet: **21.11.2012**
(21) Numéro de dépôt: 11183275.4
(22) Date de dépôt: 29.09.2011
(51) Int. Cl.: H01L 41/113, H01L 41/193, H02N 2/18

(54) **Dispositif à récupération d'énergie de pression**
Vorrichtung zur Rückgewinnung von Druckenergie
Device for recovering pressure energy

(30) Priorité: 29.09.2010 FR 1057867
(43) Date de publication de la demande: 04.04.2012
(73) Titulaire: Commissariat à l'Énergie Atomique et aux Énergies Alternatives, 75015 Paris (FR)
(72) Inventeur: Jean-Mistral, Claire, 69006 Lyon (FR)
(74) Mandataire: de Beaumont, Michel

(56) Documents cités:
- WO-A1-02/29965
- WO-A2-01/65615
- WO-A2-2010/148312

## Description

### Domaine de l'invention

La présente invention concerne un dispositif à récupération d'énergie adapté à convertir l'énergie mécanique d'une force de pression exercée sur un actionneur en énergie électrique.

### Exposé de l'art antérieur

On a proposé d'intégrer des dispositifs à récupération d'énergie dans divers objets susceptibles de subir une force de pression exercée par un utilisateur, par exemple un interrupteur à bouton poussoir, un pèse personne, une télécommande, une pédale de bicyclette, etc.

Les dispositifs à récupération d'énergie de pression usuels comprennent un actionneur mobile en translation sous l'effet de la force de pression exercée par l'utilisateur, et un convertisseur piézoélectrique ou électromagnétique pour transformer l'énergie mécanique liée au mouvement de translation de l'actionneur en énergie électrique. On notera qu'on entend ici par actionneur un organe d'actionnement via lequel la force mécanique à exploiter est transmise au convertisseur. Toutefois, de tels systèmes peuvent généralement aussi être utilisés en tant que convertisseurs électromécaniques. Dans ce cas, le dispositif est alimenté en énergie électrique, et convertit cette énergie en énergie mécanique, entraînant le déplacement de l'actionneur.

Un inconvénient de ces dispositifs réside dans le faible rendement des convertisseurs piézoélectriques ou électromagnétiques utilisés. A titre d'exemple, lorsqu'on exerce une force de 10 N sur un interrupteur à bouton poussoir adapté à subir un déplacement de 3 mm, la quantité d'énergie mécanique disponible est de 30 mJ. Les dispositifs actuels permettent au mieux de fournir 0,2 à 0,5 mJ d'énergie électrique utile, soit un rendement inférieur à 2 %.

Un autre inconvénient de ces dispositifs réside dans le nombre de pièces relativement important nécessaire à leur fabrication.

La demande internationale WO01/65615 décrit des transducteurs utilisant des membranes en polymère électro-actifs pour convertir de l'énergie mécanique en énergie électrique.

### Résumé

Ainsi, un objet d'un mode de réalisation de la présente invention est de prévoir un dispositif à récupération d'énergie palliant tout ou partie des inconvénients des solutions existantes.

Un objet d'un mode de réalisation de la présente invention est de prévoir un dispositif à récupération d'énergie de pression présentant un meilleur rendement que les solutions existantes.

Un objet d'un mode de réalisation de la présente invention est de prévoir un tel dispositif adapté à être intégré aisément à tout type d'objet susceptible de subir une force de pression extérieure.

Un objet d'un mode de réalisation de la présente invention est de prévoir un tel dispositif facilement adaptable à tout type d'objet d'usage courant.

Un objet d'un mode de réalisation de la présente invention est de prévoir un tel dispositif facile à réaliser avec peu de pièces.

Ainsi, un mode de réalisation de la présente invention prévoit un dispositif à récupération d'énergie comprenant: une membrane en polymère électro-actif ; un actionneur mobile en translation selon une première direction non parallèle au plan moyen de la membrane ; un organe de conversion du mouvement de l'actionneur en un mouvement d'étirement de la membrane selon au moins une deuxième direction du plan moyen de la membrane ; et des moyens de polarisation de la membrane comprenant un électret.

Selon un mode de réalisation de la présente invention, l'organe de conversion convertit en outre le mouvement de l'actionneur en un mouvement d'étirement de la membrane selon au moins une troisième direction du plan moyen de la membrane.

Selon un mode de réalisation de la présente invention, cet organe comprend au moins deux premiers bras rigides, mobiles en rotation autour d'un premier axe solidaire de l'actionneur et approximativement orthogonal aux première et deuxième directions, les deux premiers bras étant reliés à la membrane respectivement en deux points distincts de la deuxième direction.

Selon un mode de réalisation de la présente invention, l'organe de conversion comprend en outre au moins deux deuxièmes bras rigides, mobiles en rotation autour d'un deuxième axe solidaire de l'actionneur et approximativement orthogonal aux première et troisième directions, les deux deuxièmes bras étant fixés à la membrane respectivement en deux points distincts de la troisième direction.

Selon un mode de réalisation de la présente invention, le dispositif à récupération d'énergie comprend en outre des moyens de rappel vers une position de repos.

Selon un mode de réalisation de la présente invention, l'électret est positionné sous la membrane et forme une surface coïncidant approximativement, en vue de dessus, avec la membrane, et présentant un relief ondulé dans des plans orthogonaux à la membrane.

Selon un mode de réalisation de la présente invention, l'électret est en Téflon chargé.

Un autre mode de réalisation de la présente invention prévoit un interrupteur à bouton poussoir intégrant un dispositif à récupération d'énergie tel que mentionné ci-dessus.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles:
la figure 1A est une vue en coupe illustrant de façon schématique et partielle un mode de réalisation d'un dispositif à récupération d'énergie de pression ;
la figure 1B est une vue de dessus schématique et partielle du dispositif de la figure 1A ;
les figures 2A et 2B sont des vues en coupe illustrant de façon schématique le dispositif à récupération d'énergie des figures 1A et 1B, respectivement dans des première et deuxième positions de fonctionnement ;
la figure 3 est une vue en coupe illustrant de façon schématique un autre mode de réalisation d'un dispositif à récupération d'énergie de pression ;
la figure 4A est une vue en perspective représentant de façon schématique et partielle une variante de réalisation du dispositif à récupération d'énergie de la figure 3 ;
la figure 4B est une vue en coupe schématique et partielle du dispositif de la figure 4A ; et
la figure 5 est une vue en coupe représentant de façon schématique et partielle une variante de réalisation du dispositif à récupération d'énergie des figures 4A et 4B.

### Description détaillée

Par souci de clarté, de mêmes éléments ont été désignés par de mêmes références aux différentes figures et, de plus, les diverses figures ne sont pas tracées à l'échelle.

On propose ici un dispositif à récupération d'énergie adapté à convertir une force de pression en énergie électrique, à l'aide d'une membrane en polymère électro-actif.

On connaît des membranes souples déformables faisant appel à des polymères électro-actifs, et plus particulièrement aux polymères diélectriques, capables de transformer une déformation mécanique qu'elles subissent en une énergie électrique. Typiquement, un film de polymère forme le diélectrique d'un élément capacitif variable et est pris en sandwich entre deux électrodes souples.

En mode convertisseur électromécanique, lorsqu'une tension est appliquée à la structure ainsi formée (polymère + électrodes), cette dernière s'étire dans le plan et se contracte selon son épaisseur. En mode convertisseur mécano-électrique, le principe de conversion est un principe électrostatique soit une variation de l'énergie stockée au sein d'une capacité variable selon trois directions (plan et épaisseur). Cette variation de capacité est induite par un mouvement mécanique (vibrations, forces...). Les polymères diélectriques sont donc des matériaux passifs nécessitant la réalisation d'un cycle énergétique pour convertir de l'énergie mécanique en électricité. Le polymère est déformé puis chargé. Une énergie électrique initiale est stockée dans la capacité formée par le polymère diélectrique. Puis, le polymère bouge mécaniquement, la capacité varie de telle sorte que l'énergie électrique stockée soit amplifiée. Cette phase dite phase active se fait généralement à charge Q constante ou à tension V constante. Puis, l'énergie électrique est retirée du polymère et ce dernier retrouve ses dimensions d'origine.

L'énergie électrique qui en résulte peut être traitée et mise en forme par un système approprié pour alimenter un dispositif annexe ou être stockée. Les cycles électriques de charge et de décharge sont synchronisés par un circuit de gestion électrique adapté.

Des exemples de réalisation de membranes électro-actives de ce type sont décrits dans la demande de brevet française 2936650. De telles membranes présentent un rendement de conversion mécano-électrique nettement supérieur au rendement des convertisseurs piézoélectriques ou électromagnétiques usuels.

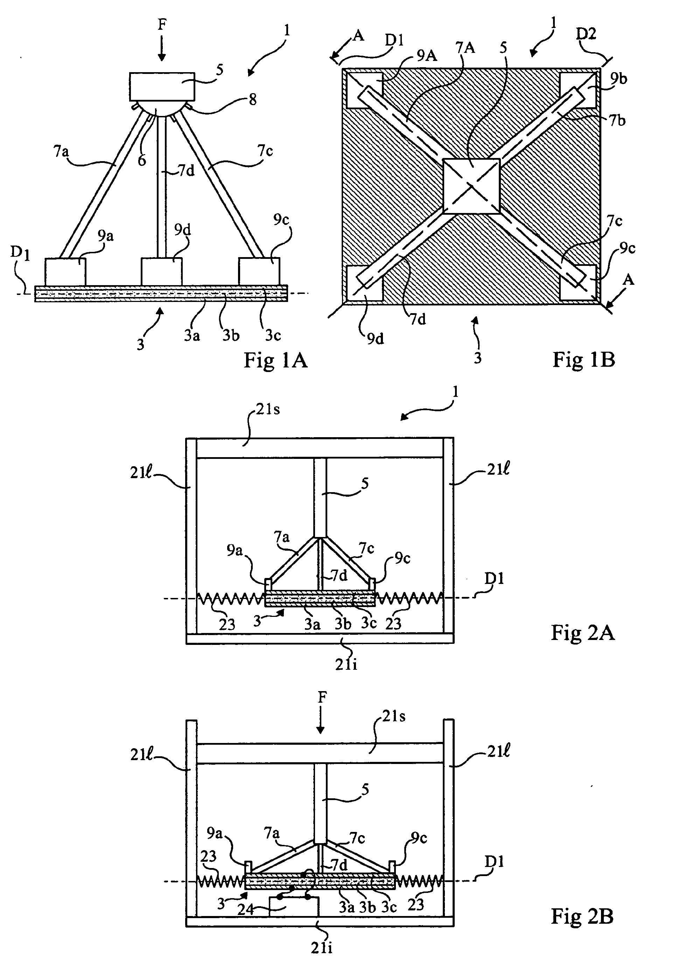

Les figures 1A et 1B illustrent de façon schématique et partielle un exemple d'un mode de réalisation d'un dispositif 1 à récupération d'énergie. La figure 1B est une vue de dessus, et la figure 1A est une vue en coupe selon la ligne A-A de la figure 1B.

Le dispositif 1 comprend une membrane électro-active déformable 3 approximativement plane, constituée d'un empilement d'une première électrode 3a, d'un polymère diélectrique 3b, et d'une seconde électrode 3c. Dans cet exemple, la membrane 3 a, en vue de dessus (figure 1B), une forme générale approximativement carrée. On notera que la membrane n'est pas nécessairement parfaitement plane, mais pourra être ondulée ou présenter divers reliefs s'étendant de part et d'autre d'un plan moyen.

Dans cet exemple le dispositif 1 comprend en outre, en dehors du plan de la membrane et sensiblement en regard de la partie centrale de la membrane, un actionneur 5 mobile en translation selon un axe approximativement orthogonal à la membrane. Plus généralement, l'actionneur 5 pourra être mobile en translation selon un axe intersectant le plan moyen de la membrane, c'est-à-dire un axe non parallèle au plan moyen de la membrane. Dans cet exemple l'actionneur 5 est susceptible de subir une force de pression F approximativement orthogonale au plan de la membrane, et de se déplacer sous l'effet de cette force. Plus généralement, la force F pourra être une force oblique par rapport au plan moyen de la membrane, et comportant une composante verticale (orthogonale au plan de la membrane) non nulle.

Quatre bras rigides 7a à 7d relient l'actionneur 5 aux quatre coins de la membrane 3. Chaque bras 7 est fixé par une extrémité à un coin de la membrane à l'aide d'un système d'attache 9 (respectivement 9a à 9d). Le système d'attache 9 est par exemple un point de colle, une soudure, une couture, une butée d'appui, ou tout autre système adapté. Dans l'exemple représenté, les points d'attache 9a et 9c des bras 7a et 7c sont disposés aux extrémités d'une première diagonale D1 de la membrane, et les points d'attache 9b et 9d des bras 7b et 7d sont disposées aux extrémités de la seconde diagonale D2.

Du côté de leur extrémité non reliée à la membrane 3, les bras 7a à 7d sont reliés à l'actionneur 5, par exemple par l'intermédiaire d'une rotule 6 (figure lA). Les bras 7a et 7c sont articulés l'un par rapport à l'autre et par rapport à l'actionneur 5 selon un degré de liberté en rotation autour d'un axe (non représenté) de l'actionneur parallèle au plan de la membrane et orthogonal à la diagonale D1. Les bras 7b et 7d sont articulés l'un par rapport à l'autre et par rapport à l'actionneur selon un degré de liberté en rotation autour d'un axe (non représenté) de l'actionneur parallèle au plan de la membrane et orthogonal à la diagonale D2.

Lorsqu'une force de pression F approximativement orthogonale au plan de la membrane est exercée sur l'actionneur 5, le mouvement de translation de l'actionneur qui en résulte provoque l'ouverture des angles formés entre les bras 7a et 7c d'une part, et entre les bras 7b et 7d d'autre part. Il en résulte un étirement de la membrane par ses quatre coins, selon les deux diagonales D1 et D2.

Pour favoriser l'étirement de la membrane, on pourra optionnellement prévoir des moyens non représentés de maintien de la membrane dans un plan fixe. Il s'agit par exemple d'un cadre support, déformable mais plus rigide que la membrane, dans ou sur lequel est tendue la membrane, et relié en ses quatre coins aux attaches 9a à 9d. Des butées de fin de course constituées d'ergots 8 placés sur la rotule 6 peuvent être prévues pour limiter l'étirement maximal et l'étirement minimal de la membrane. Tout autre système limiteur de l'étirement de la membrane pourra être prévu.

Selon un avantage du système de récupération d'énergie proposé, la force de pression F exercée par l'utilisateur conduit à étirer la membrane en polymère électroactif 3 selon les deux directions distinctes correspondant aux diagonales D1 et D2, ce qui permet de maximiser la quantité d'énergie récupérée. En outre, la force F est amplifiée par le bras de levier formé par les bras 7a à 7d.

L'invention ne se restreint toutefois pas à cette configuration particulière. En particulier, on pourra choisir de n'étirer la membrane que dans une seule direction, à l'aide d'un mécanisme à deux bras, ou selon plus de deux directions, à l'aide d'un mécanisme en araignée comportant deux bras pour chaque direction d'étirement souhaitée. En outre, la membrane pourra avoir toute autre forme que celle représentée en figure 1B, par exemple une forme rectangulaire, octogonale, circulaire, triangulaire, etc. Si la membrane est légèrement ondulée et/ou présente des reliefs autour d'un plan moyen, lors de son étirement, elle peut aussi se déplacer dans un plan sensiblement vertical.

Plus généralement, on propose ici un dispositif à récupération d'énergie comprenant une membrane plane en polymère électro-actif, un actionneur mobile en translation selon une direction orthogonale au plan de la membrane, et un organe de conversion du mouvement de l'actionneur en un mouvement d'étirement de la membrane selon une ou plusieurs directions de son plan.

Les figures 2A et 2B sont des vues en coupe illustrant de façon schématique le dispositif à récupération d'énergie 1 des figures 1A et 1B, respectivement dans des première et deuxième positions de fonctionnement.

Dans cet exemple, le système décrit en relation avec les figures 1A et 1B est intégré dans un boîtier 21 de forme générale parallélépipédique. La membrane 3 est positionnée dans un plan horizontal parallèle à des parois opposées inférieure 21i et supérieure 21s du boîtier 21. Des moyens de support non représentés peuvent être prévus pour maintenir la membrane dans ce plan.

On utilise ici et dans la suite de la présente description les termes d'orientation et de positionnement "inférieur", "supérieur", "latéral", "horizontal", et "vertical" en se référant arbitrairement à l'orientation des figures 2A et 2B. Toutefois, il est entendu que le système de récupération d'énergie proposé est adapté à fonctionner quelle que soit l'orientation du boîtier 21.

L'actionneur 5 et les bras 7a à 7d sont placés du côté de la membrane 3 opposé à la paroi inférieure 21i, et l'actionneur 5 est fixé à la paroi supérieure 21s. La paroi supérieure 21s est mobile en translation ou déformable selon une direction verticale, de façon que l'application d'une force de pression F sensiblement verticale (figure 2B) sur cette paroi (ou une force non verticale mais présentant une composante verticale non nulle) entraîne la mise en mouvement de l'actionneur 5. Ainsi, l'application d'une force de pression F verticale sur la paroi 21s conduit à étirer la membrane 3 selon ses diagonales.

Des moyens de rappel sont en outre prévus pour ramener le dispositif 1 vers une position de repos lorsque la force de pression F cesse de s'exercer. Dans cet exemple, les moyens de rappel sont constitués de ressorts 23 en appui entre des faces latérales 211 du boîtier 21 et les points d'attache 9 de la membrane. Tout autre mécanisme de rappel adapté peut être prévu. A titre d'exemple, un ressort peut être prévu entre les bras 7a et 7c et/ou entre les bras 7b et 7d (figure 1B). On notera par ailleurs que, du fait de son élasticité, la membrane contribue naturellement à ramener le dispositif 1 vers une position de repos. Si cette contribution est suffisante, on pourra se passer de moyens de rappel complémentaires.

Le dispositif 1 comprend en outre un circuit de gestion électrique 24 pour appliquer une tension de polarisation entre les électrodes 3a et 3c lorsque la membrane est étirée, et pour récupérer les charges générées par le polymère diélectrique 3b lorsque la membrane se rétracte. Dans un exemple de réalisation, un élément piézoélectrique peut être associé aux moyens de rappel 23 pour générer la tension de polarisation requise. L'élément piézoélectrique pourra même constituer le moyen de rappel lui-même. Une adaptation de niveau de tension est alors nécessaire, via un convertisseur entre l'élément piézoélectrique et la membrane électro-active.

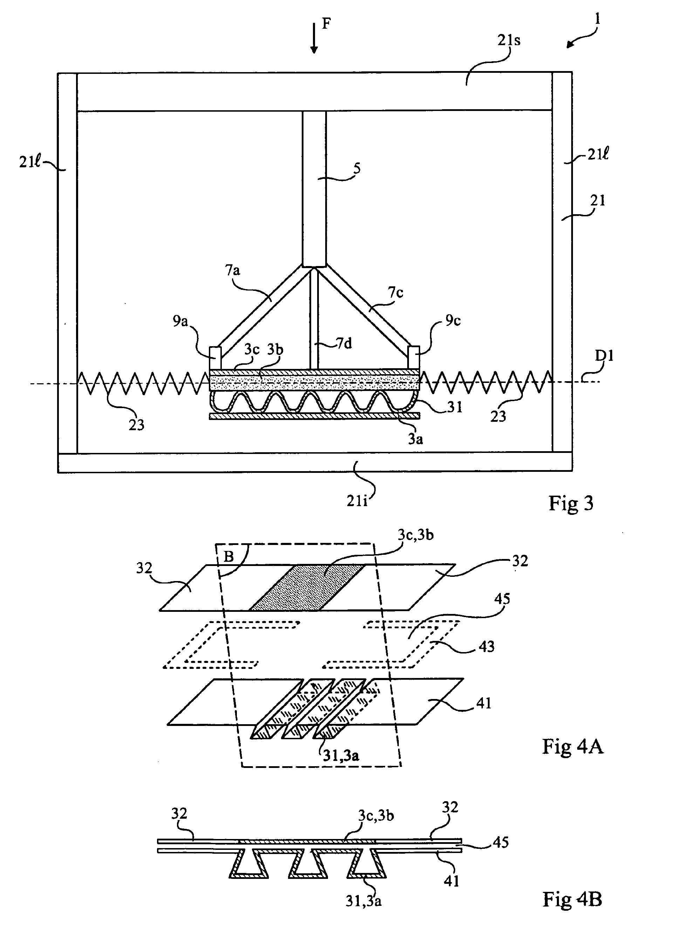

La figure 3 est une vue en coupe illustrant de façon schématique un mode de réalisation préféré du dispositif à récupération d'énergie 1 des figures 2A et 2B. On propose ici de polariser la membrane à l'aide d'un électret 31, c'est-à-dire un élément en un matériau diélectrique présentant un état de polarisation électrique quasi-permanent. On pourra par exemple utiliser un électret en Téflon chargé.

L'électret 31 forme une surface coïncidant approximativement, en vue de dessus, avec la membrane 3, et présentant un relief ondulé, par exemple en vague, en triangle ou en rectangle, dans un ou plusieurs plans orthogonaux à la membrane. Une telle forme en serpentin permet à l'électret de se déployer et de suivre les déformations de la membrane. Pour une membrane non étirée, l'électret est ondulé et pour une membrane étirée au maximum, l'électret est par exemple plan et parallèle à la membrane. L'électret 31 est placé entre la couche diélectrique 3b et l'électrode 3a. L'électrode 3a peut être plane, comme représenté sur la figure 3, ou se conformer à l'électret 31. L'électret 31 est par exemple fixé à la couche 3b par des points de colle disposés en des points supérieurs du relief ondulé, ou par tout autre système d'attache connu de l'art antérieur. Plus généralement, la forme de l'électret et le moyen de fixation de l'électret sous la membrane 3 sont choisis pour que l'électret suive les déformations de la membrane.

Au repos, l'électret possède une charge permanente Qi qui induit l'apparition de charges sur les deux électrodes : un équilibre électrostatique de la structure doit être maintenu. La capacité formée par le diélectrique est ainsi polarisée. Lorsque la membrane électro-active se déforme, la valeur de la capacité du système change. Les charges présentes sur les deux électrodes se réorganisent pour assurer un équilibre électrostatique. Ces mouvements de charges s'effectuent au travers d'une charge (résistance...). C'est la tension aux bornes de cette charge qui constitue l'énergie dite récupérée. Il est à noter qu'en fonction du sens du mouvement mécanique de la membrane électro-active, les charges circulent dans un sens ou dans l'autre au travers de la résistance (tension alternative). Un avantage de ce mode de réalisation est que le circuit de gestion électrique utilisé est beaucoup plus simple que le circuit qui serait utilisé dans une solution hybride à base de piézoélectrique. L'utilisation d'un électret permet d'obtenir directement une tension de polarisation élevée, sans qu'il faille prévoir un convertisseur de tension complémentaire. A titre d'exemple, un électret en Téflon chargé permet d'obtenir un potentiel de surface permanent de l'ordre de 300 V. Le Téflon présente en outre l'avantage d'être suffisamment souple pour suivre les déformations de la membrane.

On notera que toute autre forme et/ou disposition adaptée de l'électret pourra être envisagée.

La figure 4A est une vue en perspective représentant de façon schématique et partielle une variante de réalisation du dispositif à récupération d'énergie de la figure 3.

La figure 4B est une vue en coupe partielle du dispositif de la figure 4A selon le plan B de la figure 4A.

Dans cet exemple, la membrane constituée par l'empilement de l'électrode 3c et du polymère 3b est rectangulaire et est encadrée par des parties non actives 32 dont le rôle est de maximiser les déformations mécaniques de la membrane. La membrane n'est susceptible d'être déformée que dans une direction. Le mécanisme de conversion du mouvement de pression exercé par l'utilisateur en un mouvement d'étirement de la membrane est par exemple un mécanisme à deux bras.

Il est prévu un support 41 pour assurer la planéité de la membrane et pour éviter un étirement excessif pouvant conduire à sa rupture. Le support 41 forme (en vue de dessus) une surface approximativement rectangulaire de dimensions au moins égales à celles de la membrane et des parties actives 32, et présente un relief en serpentin dans des plans orthogonaux à la membrane et parallèles à sa direction d'étirement (figure 4B).

On propose ici de réaliser le support 41 en un matériau à polarisation électrique quasi-permanente tel que du Téflon chargé, de façon que ce support assure directement la polarisation de la membrane. On notera que seules la ou les régions du support 41 en regard de la membrane 3c, 3b forment un électret. Ces régions sont ici constituées par l'empilement de l'électret 31 proprement dit et de l'électrode inférieure 3a de la membrane. On pourra par exemple réaliser un support 41 en une seule pièce et ne venir charger localement que ces régions de façon qu'elles assurent leur fonction d'électret. On pourra aussi prévoir un support 41 formé en plusieurs pièces de matériaux distincts, la ou les portions du support en regard de la membrane 3c, 3b étant par exemple formées en Téflon chargé. En variante, on pourra aussi prévoir un support 41 en un matériau quelconque, par exemple choisi pour ses propriétés de rigidité et d'élasticité, et revêtir certaines parties de ce support d'un matériau à polarisation électrique quasi-permanente. Une cale périphérique 43 (figure 4A) est prévue entre les parties non actives 32 de la membrane 3b, 3c et l'électret/support 41, de façon qu'une zone d'air 45 sépare la membrane du support. Ceci permet que la membrane soit libre de s'étirer ou de se rétracter uniformément sur toute sa surface quelle que soit la géométrie du support.

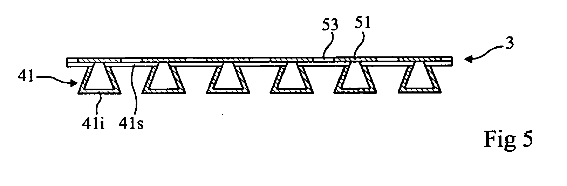

La figure 5 est une vue en coupe dans le même plan que la figure 4B, représentant de façon schématique et partielle une variante de réalisation du dispositif à récupération d'énergie des figures 4A et 4B.

Dans cet exemple, aucune cale n'est prévue entre le support 41 et la membrane. Ainsi, une partie supérieure 41s du support 41 (correspondant aux tronçons supérieurs du serpentin) est directement en contact avec la membrane. A la différence du dispositif représenté aux figures 4A et 4B, cette partie supérieure 41s n'est pas chargée électriquement. En revanche, la partie inférieure 41i du support 41 (correspondant aux tronçons latéraux et inférieurs du serpentin de la figure 5) constitue un électret chargé. Les parties inférieures 41i sont en fait constituées par l'empilement de l'électret 31 et de l'électrode 3a (figure 3).

La membrane 3 est constituée d'une alternance de bandes électro-actives 51 et de bandes non actives 53 juxtaposées. Les bandes électro-actives 51 sont constituées par l'empilement de l'électrode supérieure 3c et du polymère diélectrique 3b (voir figure 3), et sont disposées en regard des électrets localisés au niveau des régions inférieures 41i du support 41. Les bandes non actives 53 sont par exemple seulement constituées par l'électrode supérieure 3c, et ne comprennent pas de polymère électro-actif. Ainsi, la structure est composée d'une pluralité de générateurs électro-actifs juxtaposés.

Des modes de réalisation particuliers de la présente invention ont été décrits. Diverses variantes et modifications apparaîtront à l'homme de l'art.

En particulier, on a mentionné ci-dessus divers exemples d'utilisation d'un dispositif à récupération d'énergie de pression. L'invention ne se restreint pas à ces exemples. Le dispositif proposé pourra être utilisé dans tout type d'objet susceptible de subir une force de pression de la part d'un utilisateur ou de la part d'un élément extérieur. On pourra par exemple utiliser ce dispositif dans des dalles de revêtement de sol, dans une selle de vélo, dans un piétement de chaise.

En outre, l'homme de l'art saura adapter le système de récupération d'énergie proposé pour exploiter non pas uniquement une force de pression directe exercée sur un actionneur, mais également d'autres types de force, par exemple une force exercée via un élément en rotation tel qu'une poignée de porte ou un verrou, qui mettra en mouvement les bras d'étirement de la membrane.

De plus, on a représenté aux figures 1A à 3 des systèmes de récupération d'énergie dans lesquels l'actionneur 5 est disposé sensiblement en regard de la partie centrale de la membrane. L'invention ne se restreint bien entendu pas à ce cas particulier. On pourra par exemple prévoir un actionneur 5 décentré par rapport à la membrane, et utiliser des bras d'étirement de longueurs distinctes reliés aux extrémités de la membrane.

Par ailleurs, on a mentionné ci-dessus l'utilisation de Téflon chargé pour former un électret de polarisation de la membrane électro-active. Tout autre matériau d'électret adapté pourra être utilisé.

En outre, on a décrit et représenté des dispositifs à récupération d'énergie comprenant une membrane électro-active constituée d'un polymère diélectrique pris en sandwich entre deux électrodes. On notera que la membrane électro-active pourra être constituée d'un empilement alterné de plusieurs couches de polymère diélectrique et d'électrodes.

Les inventeurs ont constaté qu'en utilisant une membrane constituée d'un empilement alterné de 5 à 10 couches de polymère diélectrique et de couches d'électrodes, le dispositif proposé permet de récupérer entre 2 et 10 mJ d'énergie électrique utile dans un interrupteur à bouton poussoir recevant une énergie mécanique de 30 mJ de la part d'un utilisateur.

## Revendications

1. Dispositif à récupération d'énergie comprenant :
une membrane (3) en polymère électro-actif ;
un actionneur (5) mobile en translation selon une première direction (F) non parallèle au plan moyen de la membrane ;
un organe (7, 9) de conversion du mouvement de l'actionneur en un mouvement d'étirement de la membrane selon au moins une deuxième direction (D1) du plan moyen de la membrane ; charactérisé en ce qu'il comprend
des moyens (31 ; 41) de polarisation de la membrane comprenant un électret.

2. Dispositif selon la revendication 1, dans lequel ledit organe convertit en outre le mouvement de l'actionneur (5) en un mouvement d'étirement de la membrane selon au moins une troisième direction (D2) du plan moyen de la membrane.

3. Dispositif selon la revendication 1 ou 2, dans lequel ledit organe comprend au moins deux premiers bras rigides (7a, 7c), mobiles en rotation autour d'un premier axe solidaire de l'actionneur et approximativement orthogonal aux première et deuxième (D1) directions, les deux premiers bras étant reliés à la membrane respectivement en deux points distincts (9a, 9c) de la deuxième direction (D1).

4. Dispositif selon la revendication 3 dans son rattachement à la revendication 2, dans lequel ledit organe comprend en outre au moins deux deuxièmes bras rigides (7b, 7d), mobiles en rotation autour d'un deuxième axe solidaire de l'actionneur et approximativement orthogonal aux première et troisième (D2) directions, les deux deuxièmes bras étant fixés à la membrane respectivement en deux points distincts (9b, 9d) de la troisième direction (D2).

5. Dispositif selon l'une quelconque des revendications 1 à 4, comprenant en outre des moyens de rappel (23) vers une position de repos.

6. Dispositif selon l'une quelconque des revendications 1 à 5, dans lequel l'électret (31) est positionné sous la membrane (3) et forme une surface coïncidant approximativement, en vue de dessus, avec la membrane, et présentant un relief ondulé dans des plans orthogonaux à la membrane.

7. Dispositif selon l'une quelconque des revendications 1 à 6, dans lequel l'électret (31 ; 41) est en Téflon chargé.

8. Interrupteur à bouton poussoir intégrant un dispositif selon l'une quelconque des revendications 1 à 7.

## Claims

1. A power recovery device comprising:
an electroactive polymer membrane (3);
an actuator (5) capable of moving along a first direction (F) non-parallel to the mid-plane of the membrane;
a member (7, 9) for converting the motion of the actuator into a stretching of the membrane along at least one second direction (D1) of the mid-plane of the membrane;
**characterized in that** it comprises means (31; 41) for biasing the membrane comprising an electret.

2. The device of claim 1, wherein said member further converts the motion of the actuator (5) into a stretching of the membrane along at least one third direction (D2) of the mid-plane of the membrane.

3. The device of claim 1 or 2, wherein said member comprises at least two first rigid arms (7a, 7c), mobile in rotation around a first axis forming one block with the actuator and approximately orthogonal to the first and second (D1) directions, the first two arms being connected to the membrane respectively in two different points (9a, 9c) of the second direction (D1).

4. The device of claims 2 and 3, wherein said member comprises at least two second rigid arms (7b, 7d), mobile in rotation around a second axis solid with the actuator and approximately orthogonal to the first and third (D2) directions, the first two arms being connected to the membrane respectively in two different points (9b, 9d) of the third direction (D2).

5. The device of any of claims 1 to 4, further comprising means for returning (23) to an idle position.

6. The device of any of claims 1 to 5, wherein the electret (31) is positioned under the membrane (3) and forms a surface approximately coinciding, in top view, with the membrane, and having a corrugated relief in planes orthogonal to the membrane.

7. The device of any of claims 1 to 6, wherein the electret (31; 41) is made of charged Teflon.

8. A push-button switch comprising the device of any of claims 1 to 7.

## Patentansprüche

1. Eine Energiewiedergewinnungsvorrichtung, die folgendes aufweist:
eine elektroaktive Polymermembran (3);
einen Betätiger (5), der in der Lage ist, sich entlang einer ersten Richtung (F), die nicht parallel zur Mittelebene der Membran ist, zu bewegen;
ein Glied (7, 9) zum Umwandeln der Bewegung des Betätigers in ein Dehnen der Membran entlang wenigstens einer zweiten Richtung (D1) der Mittelebene der Membran;
**dadurch gekennzeichnet, dass** die Vorrichtung Mittel (31; 41) aufweist zum Polarisieren der Membran, welche ein Elektret aufweisen.

2. Vorrichtung nach Anspruch 1, wobei das Glied ferner die Bewegung des Betätigers (5) in ein Dehnen der Membran entlang wenigstens einer dritten Richtung (D2) der Mittelebene der Membran umwandelt.

3. Vorrichtung nach Anspruch 1 oder 2, wobei das Glied wenigstens zwei starre Arme (7a, 7c) aufweist, die in einer Drehrichtung um eine erste Achse welche einen Block mit dem Betätiger bildet und ungefähr senkrecht zu der ersten und zweiten D1-Richtung bewegbar ist, wobei die ersten zwei Arme mit der Membran jeweils an zwei unterschiedlichen Punkten (9a, 9c) entlang der Seitenrichtung (D1) verbunden sind.

4. Vorrichtung nach Anspruch 2 und 3, wobei das Glied wenigstens zwei starre Arme (7b, 7d) aufweist, die in einer Drehrichtung um eine zweite Achse bewegbar sind, die fest mit dem Betätiger ist und sich ungefähr senkrecht zu der ersten und der dritten D2-Richtungen erstreckt, wobei die ersten zwei Arme mit der Membran jeweils an zwei unterschiedlichen Punkten (9b, 9d) entlang der dritten Richtung (D2) verbunden sind.

5. Vorrichtung nach einem der Ansprüche 1 bis 4, die ferner Mittel (23) zum Rückstellen zu einer Ruheposition aufweist.

6. Vorrichtung nach einem der Ansprüche 1 - 5, wobei das Elektret (31) unterhalb der Membran (3) positioniert ist und die in einer Draufsicht eine Oberfläche bildet, die ungefähr mit der der Membran übereinstimmt, und die ein gewelltes Relief in Ebenen senkrecht zur Membran aufweist.

7. Vorrichtung nach einem der Ansprüche 1 - 6, wobei das Elektret (31; 41) aus geladenem Teflon besteht.

8. Druckknopfschalter, der die Vorrichtung nach einem der Ansprüche 1 - 7 aufweist.
